(19) Europäisches Patentamt / European Patent Office / Office européen des brevets

(11) **EP 3 070 874 B1**

(12) **EUROPEAN PATENT SPECIFICATION**

(45) Date of publication and mention
of the grant of the patent:
**31.05.2017 Bulletin 2017/22**

(51) Int Cl.:
*H04B 10/00* (2013.01)  *H04L 7/00* (2006.01)
*H03L 7/087* (2006.01)

(21) Application number: **15159267.2**

(22) Date of filing: **16.03.2015**

(54) **A SYSTEM FOR SYNCHRONIZING OSCILLATING SIGNALS AND A METHOD OF OPERATING THE SYSTEM**

SYSTEM ZUR SYNCHRONISIERUNG VON OSZILLIERENDEN SIGNALEN UND VERFAHREN ZUM BETRIEB DES SYSTEMS

SYSTÈME DE SYNCHRONISATION DE SIGNAUX D'OSCILLATION ET PROCÉDÉ D'EXPLOITATION DE CE SYSTÈME

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**21.09.2016 Bulletin 2016/38**

(73) Proprietor: **Deutsches Elektronen-Synchrotron DESY**
**22603 Hamburg (DE)**

(72) Inventors:
• **Jablonski, Szymon**
**22547 Hamburg (DE)**

• **Schlarb, Holger**
**22549 Hamburg (DE)**

(74) Representative: **Seemann & Partner Patentanwälte mbB**
**Raboisen 6**
**20095 Hamburg (DE)**

(56) References cited:
**EP-A2- 0 738 055       EP-A2- 2 246 946**
**US-A1- 2005 180 575    US-A1- 2011 123 200**

**Description**

The invention relates to a system for synchronizing an oscillating reference signal and an oscillating remote signal, the system comprising a sender with a reference oscillator generating the reference signal and a receiver with a remote signal source providing the remote signal, wherein the sender and the receiver are arranged remote from each other and are linked by an optical fiber. Furthermore, the invention relates to a method of operating the system for synchronizing an oscillating reference signal and an oscillating remote signal.

Present and future 4th-generation light sources, for example the next generation of accelerator-driven light sources, will produce sub 100 fs high brightness x-ray pulses. Precise timing and synchronization systems are needed to operate these light sources, which are for example based on linear accelerator driven free electron lasers (FELs). Traditionally, coaxial cables are used for the RF-radio frequency and microwave signal distribution. However, coaxial cables are inadequate for long-distance signal distribution due to high insertion losses. Alternatively, optical fibers are applied for signal distribution in recent systems. An optical system based on a continuous wave (CW) laser source for the radio frequency (RF) signal distribution is for example known from Wilcox, R.: Optics Letters, Vol. 34, No. 20, 3050-3052, October 2009.

The CW laser-based systems, however, suffer from two main technical drawbacks. Firstly, there is a relatively high temperature coefficient of the fiber refraction index. Secondly, the fiber offers a relatively low signal to noise ratio, which degrades the timing jitter of a transmitted microwave signal. The system, which is disclosed in the named reference, includes a delay control for compensation of the refraction index change. The delay control unit is located in the receiver; the delay compensation is performed electronically.

The delay sensing is performed using a continuous optical carrier. The optical phase delay through the fiber is measured using a heterodyne interferometer. However, in this system, each receiver has to be equipped with the necessary optical and electronic components for detection of the delay. Therefore, the known system represents a cost intensive solution.

In other technical approaches, a forward and backward reflection of the signal through the fiber link is performed, wherein phase drifts are compensated in the transmitter unit by cooling or heating an intermediate fiber spool or by cooling or heating the laser source.

It is an object of the invention to provide a system for synchronizing an oscillating reference signal and an oscillating remote signal and a method of operating said system, wherein high precision of the synchronization between the reference signal and the remote signal shall be achievable with reduced constructive effort.

The object is solved by a system for synchronizing an oscillating reference signal and an oscillating remote signal, the system comprising a sender with a reference oscillator generating the reference signal and a receiver with a remote signal source providing the remote signal, wherein the sender and the receiver are arranged remote from each other and are linked by an optical fiber, wherein the sender further comprises:

- a laser for emission of a laser beam, including an optical cou-pler for coupling the laser beam into the optical fiber,
- an optical amplitude modulator being arranged downstream the laser and being coupled to the reference oscillator for amplitude modulating the laser beam with the reference signal, and the receiver further comprises:
- an optical reflector arranged downstream a remote end of the optical fiber emitting the transmitted modulated laser beam, wherein the reflector is configured to partially reflect the transmitted modulated laser beam back through the optical fiber towards the sender, wherein the system is further enhanced in that
- the sender comprises a phase detector configured to detect a phase difference between the reference signal and a signal in a back-reflected laser beam, which is the transmitted modulated laser beam being reflected back through the optical fiber from the receiver to the sender,
- the sender and the receiver are coupled via a data link and a value of the detected phase difference is communicated via the data link from the sender to the receiver,
- the receiver comprises a further phase detector configured to detect a further phase difference between the remote signal and the reference signal in the transmitted modulated laser beam,
- the receiver is configured to correct the detected value of said further phase difference by the value of the phase difference detected by the phase detector in the sender, said value being received via the data link, for synchronizing the reference sig-nal and the remote signal.

For distribution and synchronization of microwave signals to remote locations being separated from a signal source by up to tenths of kilometers with femtosecond precision, optical fiber links are frequently applied. Microwave signals shall be signals having a frequency in the GHz range in particular between 0,1 GHz and 40 GHz. However, due to changes in the environmental conditions, such as temperature, humidity and/or mechanical vibration, the propagation time of an amplitude modulated laser signal in the fiber link varies.

Within the system according to aspects of the invention, this variation on the fiber link is detected. A small fraction of the optical beam, which is sent from the sender to the receiver, is reflected back through the fiber link to the sender. At the sender, the time dependent variation of the phase is measured with respect to the reference signal. The propagation time variation on the fiber link is determined and it is communicated to the remote receiver via the data link. This is performed to correct the phase of the remote signal, which is generated in the receiver.

The system is designed for correcting the varying delay times at the receiver. This advantageously entails that the cost-intensive units like the laser, the optical amplifier, the amplitude modulator and the phase modulator are arranged in the sender. This renders the system particularly suitable for operation in a setup, wherein a single sender provides the reference signal to a plurality of receivers. In other words, a single reference signal source is sufficient for generation of a plurality of synchronized remote signals in a very cost effective system.

Furthermore, the phase difference between the reference signal and the signal in the back-reflected laser beam, which is reflected back through the optical fiber from the receiver to the sender, is advantageously detected by a phase detector in the sender. The phase difference is therefore determined in the absence of any further complicated and sensitive optical equipment for active drift compensation of the fiber.

According to an advantageous embodiment of the invention, the receiver comprises a free oscillator as the remote signal source for generating the oscillating remote signal, wherein the further phase detector is coupled to an output of the free oscillator and to the optical fiber so as to detect the further phase difference between the remote signal and the reference signal in the transmitted modulated laser beam, and wherein the free oscillator is configured to receive the value of the phase difference detected by the phase detector in the sender via the data link and the value of the phase difference detected by the phase detector in the receiver for synchronizing the reference signal and the remote signal.

Advantageously, the free oscillator does not require an input signal for generation of the remote signal. It is merely necessary to synchronize the free oscillator with the reference oscillator. This is performed by communicating the detected phase difference via the data link from the sender to the receiver.

In another advantageous embodiment of the invention, the sender and the receiver are further linked by a clock line, which is in particular a further optical fiber, the clock line being configured for transmission of the reference signal to the remote signal source, wherein the remote signal source comprises a phase shifter and an amplifier being coupled in series and being configured to receive the reference signal as input via the clock line, wherein the remote signal source is further configured to generate the remote signal from the received reference signal and wherein the phase shifter is configured to receive the value of the phase difference detected by the phase detector in the sender via the data link and the value of the phase difference detected by the phase detector in the receiver for synchronizing the reference signal and the remote signal.

Depending on the particular implementation, it can be favorable to implement a remote signal source which is clocked using a clock line or a remote signal source having a free oscillator. The first set-up can be favorable in view of the overall cost of the system. The second set-up, the free oscillator, is more favorable in view of the achievable microwave phase noise, but more cost-intensive solution when compared to the effort for a clock line.

Advantageously, the system according to the mentioned aspects of the invention provides the opportunity for implementation of both solutions. In other words, the basic concept is flexible in that it can be operated using either a free oscillator or a clocked oscillator. Naturally, both concepts can also be combined if required in a particular situation.

In still another advantageous embodiment of the invention, the sender and the receiver each comprise a multiplexer being configured to couple the reference signal and a data signal transmitted via the data link into the optical fiber in that the data link between the sender and the receiver is also established via said optical fiber, wherein in particular the multiplexers are wavelength division multiplexers.

The data link is advantageously established using the optical fiber, which is also applied for synchronization of the sender and the receiver. Consequently, there is no need for further hardware such as a data cable or the like for use as a data link. In particular, if the sender and the receiver are installed having a great distance there between, the embodiment is favorable in view of the overall cost and effort for installation of the system. In the further embodiments, which do not use the optical fiber for synchronization and as a data link, the data link can be any suitable data connection, ranging from copper or coax cable to fiber links and wireless data links. The data link shall be however fast enough for transmission of synchronization data at the desired data rate.

In an advantageous embodiment of the invention, the sender comprises an optical phase modulator being arranged downstream the laser. In particular, the optical phase modulator is arranged upstream the optical amplifier example between the laser and the optical amplitude modulator, the optical phase modulator being configured to broaden a carrier frequency spectrum of the laser beam.

There is interferometric noise generated in the fiber link. This is caused by phase noise of the laser source carrier in combination with Rayleigh scattered photons along the fiber link. This effect is efficiently suppressed by broadening the carrier frequency spectrum of the laser. The carrier frequency spectrum is frequently also referred to as the laser source line width.

In another advantageous embodiment of the invention, the system comprises a sender and a plurality of receivers, wherein the sender and the receivers are arranged remote from each other, the sender is linked to every receiver by a separate optical fiber, wherein the sender comprises an optical splitter being arranged downstream the optical modulator, wherein the optical splitter is configured to split up the modulated laser beam into a plurality of split-up modulated laser beams, wherein every split-up laser beam is coupled into one of the plurality of optical fibers.

The system according to this embodiment is particularly cost-saving. The cost-effectiveness of the technical concept according to this aspect of the invention is mainly due to the fact that the expensive components such as the ultra-stable low amplitude noise continuous wave optical source, the optical amplitude modulator and the laser source linewidth broadening apparatus are required only once at the sender. Moderate cost high power optical amplifier allow for the simultaneous operation of tens of optical links at various locations. In other words, a single cost-intensive sender supplies a plurality of more economic receivers.

Advantageously, the optical fiber and/or the further optical fiber, which can serve as a data link, are single mode optical fibers, in particular polarization-maintaining optical fibers.

Multimode optical fibers are rather unsuitable due to extensive dispersion of the laser signal upon transmission of the same in said type of optical fiber. Consequently, the single mode optical fiber, in particular the polarization-maintaining optical fiber, is a good choice for significant enhancement of the performance of the system.

According to still another advantageous embodiment of the invention, the phase detector in the sender and/or the further phase detector in the receiver is a 360°-phase detector having a first channel, wherein the first channel has a first A/D-converter, in particular a direct RF-sampling A/D-converter, and the second channel has a second A/D-converter, in particular a direct RF-sampling A/D-converter, wherein the 360°-phase detector is configured to determine a 360°-phase value by comparing a first digital signal generated by the first A/D-converter and a second digital signal generated by the second A/D-converter, wherein the first A/D-converter and the second A/D-converter are housed in a package in that the first A/D-converter and the second A/D-converter experience the same environmental conditions, in particular the same environmental conditions with respect to temperature and/or humidity.

Within the context of this specification, a 360°-phase detector is a detector, which is capable of detecting phase differences between the input signal at the first channel and the input signal at the second channel over a full range of $2\pi$ or 360°.

The 360°- or $2\pi$-phase detector is capable of determining phase drifts at the remote local source and propagation time variations in the fiber link with femtosecond precision. This extraordinary high precision is achieved because the first and the second A/D-converter of the 360°-phase detector experience the same environmental conditions. In other words, effects, which influence the measurement values of the A/D-converters, apply to both A/D-converters in an at least approximately identical or similar way. Since the only value, which is of interest, is the difference between the two measurement values, namely that of the first and that of the second A/D-converter, the external influences cancel out. The differential value is determined with excellently high precision. At the same time, the measurement range is particularly broad. The phase difference is detected over a full range of 360° with excellent precision.

The 360°-phase detector is advantageously enhanced in that the first A/D-converter and the second A/D-converter are thermally coupled via a thermal bridge, wherein in particular the first and the second A/D-converter share a common leadframe, and/or are manufactured on a single and common semiconductor substrate, wherein in particular the first and the second A/D-converter are thermally coupled in that they are operable at an at least approximately identical temperature, wherein further in particular, the first and the second A/D-converter are embedded in a single common an uniform mold in that the first and the second A/D-converter experience at least approximately the same humidity.

It could be found that thermal effects significantly contribute to deviations or drift of the A/D-converters. Consequently, by arranging the two A/D-converters in one single package in that the total assembly of A/D-converters can be operated at a common temperature, a major external influence on the measurement values is compensated. The thermal effects on the measurement values, which are acquired by the first and the second A/D-converter, respectively, are identical and cancel out as the difference of inputs is the measured value.

Furthermore, the 360°-phase detector is further enhanced in that the sender is configured to receive the reference signal at the first channel and the signal in the back-reflected laser beam at the second channel and/or the further 360°-phase detector in the receiver is configured to receive the remote signal at the first channel and the reference signal in the transmitted modulated laser beam at the second channel.

The application of the 360°-phase detector according to this embodiment in the system according to aspects of the invention allows the phase difference between the reference signal and the oscillating remote signal to be determined with particularly high precision.

To further enhance the precision of the 360°-phase detector, the 360°-phase detector further comprises a splitter configured to receive a calibrating signal having a calibrating frequency, wherein the 360°-phase detector is further configured to couple the split-up calibrating signal to the first channel and to the second channel.

On the first channel, there is the first input plus the calibrating signal. Similarly, on the second channel, there is the second input plus the calibrating signal. The calibrating signal can be digitally filtered out of the input signals. This also applies to the values of the first and the second A/D-converter, respectively. Since the reference signal is a single signal, which is split-up in two identical parts, this opens up a pathway for further calibration of the two input channels. This is performed by comparing the calibrating signal-component in the first channel and that in the second channel and by adjusting the two channels in that the calibrating signal-components are identical in both channels. To be more precise, phase drift calibration is performed by comparing the phase component in a respective one of the input signals, which is due to the calibrating frequency, which should be identical in the two signals of the two channels.

The calibration of the first and the second A/D-converter can be performed completely digital, which means that the digital output values of the first and the second A/D-converter can be digitally corrected. Advantageously, this does not require any calibration measures on the hardware of the 360°-phase detector.

In still another advantageous embodiment of the invention, the system and in particular the 360°-phase detector are configured to detect a phase difference in a femtosecond range, which is in particular in a range between 1 fs and 100 fs (1 fs = $10^{-15}$ s). Further in particular, the system and in particular the 360°-phase detector are configured to detect a phase difference, which is between 10 and 100 fs.

The object is further solved by a method of operating the system, wherein the method is further enhanced in that it comprises the following steps of:

- detecting a phase difference between the reference signal and a signal in the back-reflected laser beam, which is the transmitted modulated laser beam being reflected back through the optical fiber from the receiver to the sender by the phase detector of the sender,
- transmitting the value of the detected phase difference via the data link from the sender to the receiver,
- detecting a further phase difference between the remote signal and the reference signal in the transmitted modulated laser beam by the further phase detector of the receiver,
- in the receiver, correcting the detected value of the further phase difference by the value of the phase difference detected by the phase detector of the sender, said value being received via the data link, thereby synchronizing the reference signal and the remote signal.

Same or similar advantages, which have been mentioned with respect to the system according to aspects of the invention, apply to the method in a same or similar way, therefore, these shall not by repeated.

The method is in particular enhanced in that the sender and the receiver are further linked by a clock line and the method further comprises the steps of:

- transmitting the reference signal via the clock line to the remote signal source, wherein the remote signal source of the receiver further comprises a phase shifter and an amplifier being coupled in series,
- the remote signal source receives the reference signal as input via the clock line and generates the remote signal from the received reference signal,
- receiving the value of the phase difference detected by the phase detector in the sender and by the phase detector in the receiver at the phase shifter in the receiver via the data link for synchronizing the reference signal and the remote signal.

The operation of the system using a free oscillator or an oscillator receiving the reference signal via the clock line depends on the particular requirements of the system, which are adapted to the situation, in which a calibration between a sender and a receiver has to be achieved.

For suppression of interferometric noise in the fiber link, the method further includes the step of broadening a carrier frequency spectrum of the laser beam using a phase modulator, wherein the sender therefore comprises an optical phase modulator being arranged downstream the laser source.

In another advantageous embodiment of the invention, the phase detector in the sender and/or the further phase detector in the receiver is a 360°-phase detector having a first channel, wherein the first channel has a first A/D-converter, in particular a direct RF-sampling A/D-converter, and the second channel has a second A/D-converter, in particular a direct RF-sampling A/D-converter, wherein the first A/D-converter and the second A/D-converter are housed in a package in that the first A/D-converter and the second A/D-converter experience the same environmental conditions, in particular the same environmental conditions with respect to temperature and/or humidity and wherein a 360°-phase value is determined by comparing a first digital signal generated by the first A/D-converter and a second digital signal generated by the second A/D-converter.

In particular, the 360°-phase detector in the sender receives the reference signal at the first channel and the signal in the back-reflected laser beam at the second channel and/or the further 360°-phase detector in the receiver receives the remote signal at the first channel and the reference signal in the transmitted modulated laser beam at the second channel.

The implementation of a 360°-phase detector having a first and a second A/D-converter, which are operated under almost at least approximately identical environmental conditions, is suitable for measuring the phase between the reference signal and the remote signal over a whole phase change of $2\pi$ with femtosecond precision.

Within the context of this specification, a "reference signal" or a "remote signal" is always an oscillating signal. In particular, the oscillating signal has a certain and at least proximately constant frequency. For example, the oscillating signal is a sinusodial signal. The reference signal and the remote signal are preferably microwave signals. Furthermore, within the context of this specification, a "modulated laser beam" is always an amplitude modulated laser beam. In particular, the laser beam is a continuous wave laser beam, which is amplitude modulated. The laser or laser source, which emits said laser beam, is therefore a single mode laser emitting the continuous wave amplitude modulated laser beam. The above aspects advantageously apply to all embodiments of the invention.

Further characteristics of the invention will become apparent from the description of the embodiments according to the invention together with the claims and the included drawings. Embodiments according to the invention can fulfill individual characteristics or a combination of several characteristics.

The invention is described below, without restricting the general intent of the invention, based on exemplary embodiments, wherein reference is made expressly to the drawings with regard to the disclosure of all details according to the invention that are not explained in greater detail in the text.

The drawings show in:

Fig. 1 to 6    simplified block diagrams of systems for synchronizing an oscillating reference signal and an oscillating remote signal,

Fig 7    a simplified block diagram of a system comprising a single sender and a plurality of receivers,

Fig 8    simplified block or circuit diagrams of a 360°-phase detector in a system for synchronization.

In the drawings, the same or similar types of elements or respectively corresponding parts are provided with the same reference numbers in order to prevent the item from needing to be reintroduced.

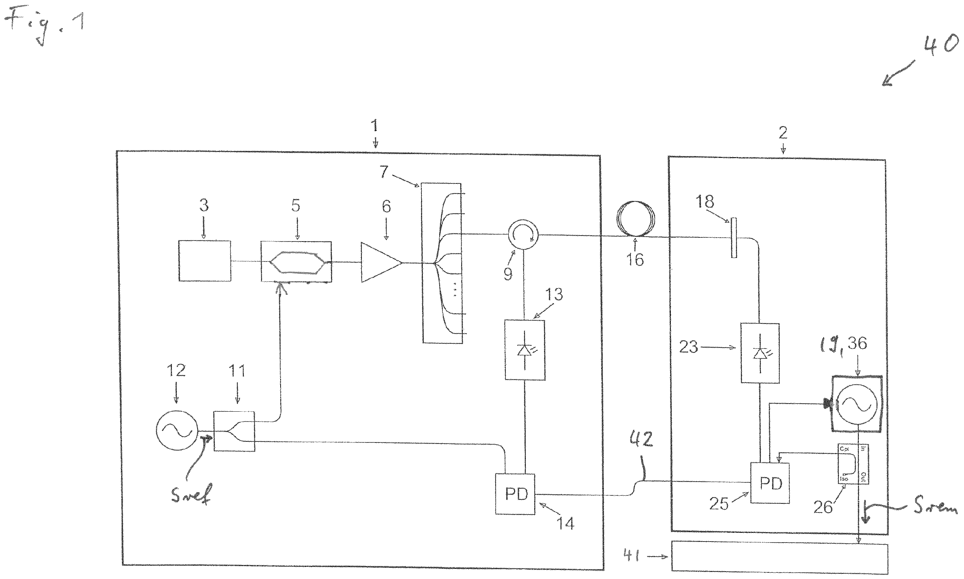

In FIG. 1, there is a simplified block diagram of a system 40 for synchronizing an oscillating reference signal Sref and an oscillating remote signal Srem.

The reference signal Sref and the remote signal Srem are oscillating signals. For abbreviation of the description, reference will be made to a "reference signal" and to a "remote signal" only.

The system 40 comprises a sender 1 and a receiver 2, which are arranged remote from each other. In particular, there is a distance ranging from several meters, in particular several 100 meters, up to kilometers, in particular up to $10^{th}$ of kilometers between the sender 1 and the receiver 2. The sender 1 and the receiver 2 are coupled via an optical fiber 16. Preferably, the optical fiber 16 is a single mode optical fiber featuring low polarization mode dispersion (PMD), or for ultimate performance a polarization-maintaing optical fiber is used. Furthermore, there is a data link 42 between the sender 1 and the receiver 2. The data link 42 can be implemented using any available and known technology, which is suitable for high speed data transmission. For example, the data link 42 can be realized using copper or coaxial wires or an optical fiber link. Even a wireless data link will be suitable.

The sender 1 comprises a laser 3, in particular an ultra-stable single mode laser. A laser beam, which is emitted by the laser 3, is amplitude modulated with the reference signal Sref, which is generated by the reference oscillator 12. The reference signal Sref is in particular a microwave signal. For example, a sinusoidal signal is applied. The same applies to the remote signal Srem. For modulation of the laser beam with the reference signal there is an optical amplitude modulator 5 implemented in the sender 1. For example, the optical modulator is a Mach-Zehnder interferometer. The reference signal Sref is split up in a splitter 11. A first part of the split up reference signal is coupled to the optical modulator 5 for modulating the laser beam. A second part of the split up reference signal Sref is coupled to a phase detector 14.

Within the context of this specification, the modulated laser beam is an amplitude modulated laser beam. However, solely for the sake of better intelligibility of the description, reference will be made to a "modulated laser beam" in the following.

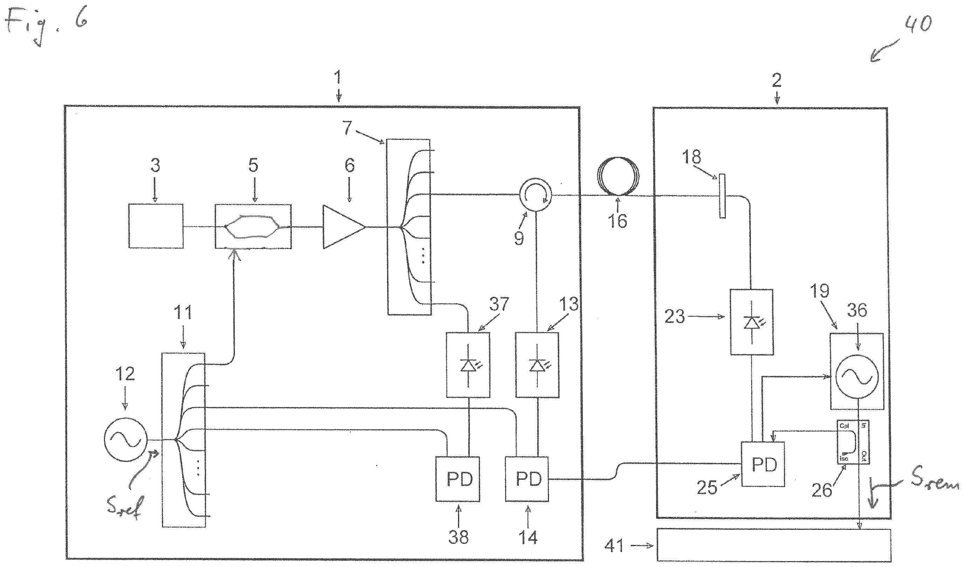

The modulated laser beam is amplified by an optical amplifier 6. For example, a low noise high power erbium-doped fiber amplifier (ED-FA) is applied. Downstream the optical amplifier 6, there is an optical splitter 7. The optical splitter 7 is configured to split up the modulated laser beam into a plurality of identical modulated laser beams, each of which is coupled into an optical fiber connecting the sender 1 to a receiver 2. For simplification of the drawing, FIG. 1 shows only a single receiver 2. However, the system 40 can comprise a plurality of receivers 2 being coupled to a single sender 1. Further details will be explained when making reference to FIG. 6 further below.

The amplified modulated laser beam, which exits the optical splitter 7, is coupled into the optical fiber 16 and is transmitted from the sender 1 to the receiver 2.

For coupling the laser beam into the fiber 16, there is an optical coupler (not shown). It is also possible that this optical coupler forms part of the laser 3. In other words, the laser beam is coupled into a fiber directly at the laser 3 and all subsequent operations and manipulations of the laser beam in the sender 1 are fiber-based.

Upon reception of the modulated laser beam at the receiver 2, a part of the transmitted laser beam is reflected back through the fiber 16 to the sender 1. This is performed using an optical reflector 18, for example a semi-transparent mirror. In this case, filtering out the back reflected laser beam from the modulated laser beam exiting the splitter 7 is performed for example using a circulator. The system 40 can also be implemented using a Faraday rotating mirror as the optical reflector 18 that alters the polarization of the reflected laser beam with respect to the incident laser beam. This enables the sender 1 to filter out the back reflected laser beam using for example a polarizing beam splitter instead of a circulator 9. However, it is not absolutely necessary to implement a polarizing optical reflector 18 and the polarizing beam splitter at the position of the circulator 9.

The back-reflected laser beam is subsequently coupled to a photo receiver 13. The photo receiver 13 detects the amplitude modulation of the back-reflected laser beam and converts it into an electrical signal. This is fed to the phase detector 14.

Since the phase detector 14 further receives the reference signal Sref, a phase difference between the phase of the back-reflected modulated laser beam and the phase of the reference signal Sref is determined.

Remembering that the sender 1 and the receiver 2 are arranged remote from each other and the distance between the two entities can be up to several kilometers, it is reasonable that the environmental conditions of the fiber link 16 vary over time. The fiber refraction index varies with temperature. This causes drift in the signal transmission time from the sender 1 to the receiver 2. Furthermore, due to varying humidity and mechanical vibration of the fiber link 16, the propagation time of the modulated laser signal varies. The variation or drift in the signal transmission time or speed is detected by comparing in the phase of the back-reflected laser beam and the phase of the reference signal Sref over time. For example, the detected phase difference will be several tens of picoseconds. In order to enable the receiver 2 to compensate for these effects, the detected phase difference is communicated from the sender 1 to the receiver 2 via a data link 42. It should be recognized that it is not absolutely necessary that the signal transmission speed of the data link 42 is as fast as the data transmission on the optical fiber 16. The change of environmental conditions, which influence the optical fiber 16, is comparably slow.

In the receiver 2, information relative to the detected phase difference is received by a further phase detector 25. This compares the received phase information, which is communicated via the data link 42, with a further phase difference, which is determined by the further phase detector 25. For this purpose, the further phase detector 25 receives an output signal of a further photo receiver 23. The further photo receiver 23 converts the modulated laser beam, which is communicated from the sender 1 to the receiver 2 via the optical fiber 16 into an electrical signal. In this signal, there is timing information of the reference signal Sref generated by the reference oscillator 12. The second input to the further phase detector 25 is received by a directional microwave coupler 26. This is configured to detect a phase of the remote signal Srem. For synchronization of the remote signal Srem and the reference signal Sref, the further phase detector 25 corrects the remote signal source for the errors on a fiber link 16, which are due to environmental changes.

In the embodiment of FIG. 1, the remote signal source 19 is a free oscillator 36. The free oscillator 36 generates the remote signal Srem, which is provided to a consumer 41. However, before the output of the remote signal Srem, it is fed to the directional microwave coupler 26, which couples a fraction of the remote signal Srem to the further phase detector 25.

The consumer 41 is for example a RF control system or a laser synchronization system, which is applied in a pump-probe experiment in an accelerator-driven light source (4th-generation light source). In particular, the light source is based on a linear accelerator driven free electron laser (FEL). Another examples are remote references for distributed phase array antennas that require long-term and high-precision synchronization for data acquisition.

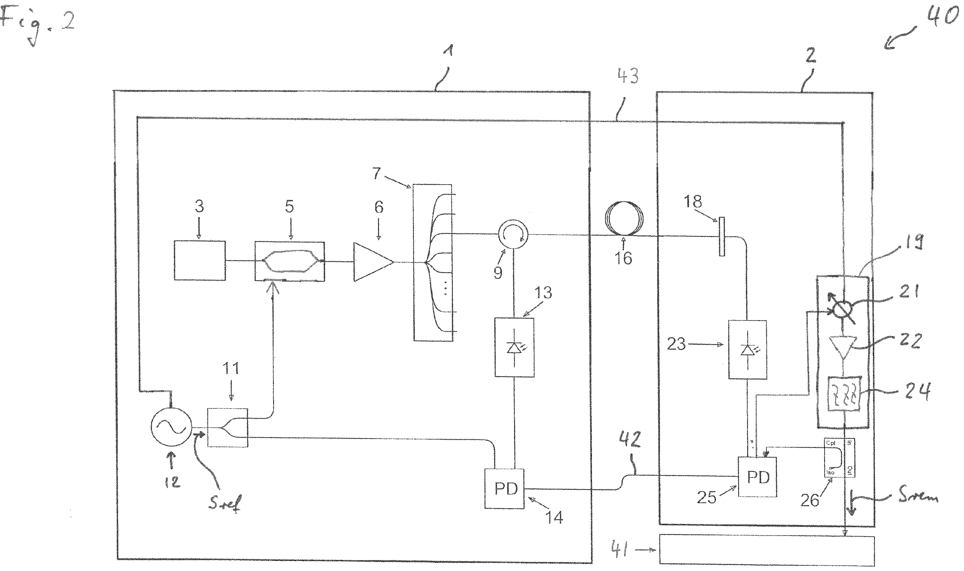

In FIG. 2, there is another system 40 for synchronizing a reference signal Sref and a remote signal Srem. The sender 1 and the receiver 2 are configured similar to the sender 1 and the receiver 2 in the embodiment of FIG. 1. Only the differences with respect to this embodiment will be explained by making reference to FIG. 2.

The sender 1 and the receiver 2 are coupled via a clock line 43. In the sender 1, the clock line 43 is coupled to the reference oscillator 12. The reference signal Sref serves as a clock signal for the remote signal source 19. The clock line 43 is in particular implemented as a link for communication of an electrical RF-signal, for example, a coaxial wire will be suitable.

The clock signal is received at the receiver 2 and is coupled to a phase shifter 21 in the remote signal source 19. Subsequently, the signal is amplified in a further amplifier 22 and undergoes filtering in the narrow-band bandpass filter 24.

For synchronization of the remote signal Srem, which is provided to the consumer 41, the phase shifter 21 is adjusted using the phase error information, which is available in the further phase detector 25 via the data link 42.

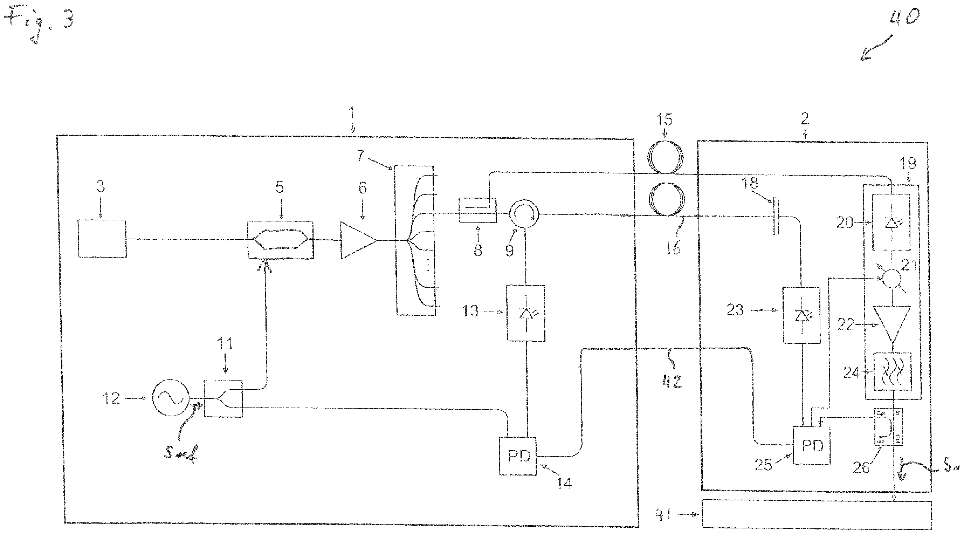

In FIG. 3, there is another system 40 for synchronizing a reference signal Sref and a remote signal Srem. The system 40 is configured similar to the embodiment of FIG. 2. Only the differences with respect to this embodiment will be explained in an attempt to abbreviate the description.

The sender 1 differs from the sender in FIG. 2 in that downstream the optical splitter 7, a further optical splitter 8 is implemented. This is for coupling the amplitude modulated laser beam containing the reference signal Sref into a further optical fiber 15. The further optical fiber 15 serves as a data link. The transmitted reference signal Sref serves as input for a remote signal source 19.

The remote signal source 19 comprises a further photo receiver 20 and, similar to the embodiment of FIG. 2, the phase shifter 21, the further amplifier 22 and the narrow-band bandpass filter 24. The further photo receiver 20 converts the amplitude modulated laser beam containing the reference signal Sref into a microwave signal.

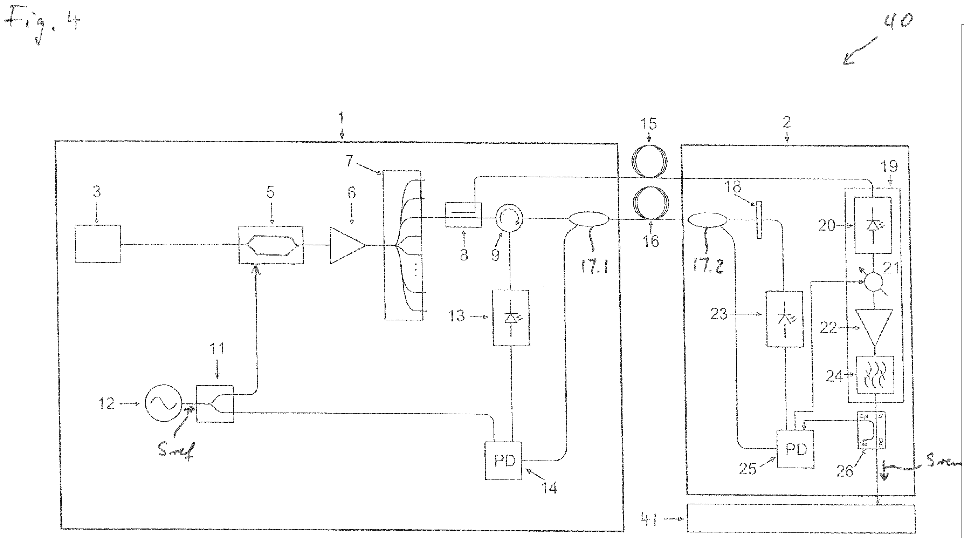

In FIG. 4, there is another system 40 for synchronizing a reference signal Sref and a remote signal Srem. The system 40 is similar to that of the embodiment in FIG. 3. Only the differences will be explained.

In the optical fiber 16, there is a first and a second multiplexer 17.1, 17.2, wherein the first multiplexer 17.1 is arranged in the sender 1 and the second multiplexer 17.2 is arranged in the receiver 2. In particular, the multiplexers 17.1, 17.2 are wave-length division multiplexers. The first multiplexer 17.1 is coupled to the phase detectors 14 at the sender 1 and to the second multiplexer 17.2 is coupled to the further phase detector 24 in the receiver 2. With the aid of the multiplexers 17.1, 17.2 the optical fiber 16 is also used as a data link. Consequently, the data link 42 being implemented as a separate entity in the embodiments of FIGs. 1 to 3 is dispensable in the embodiment of FIG. 4.

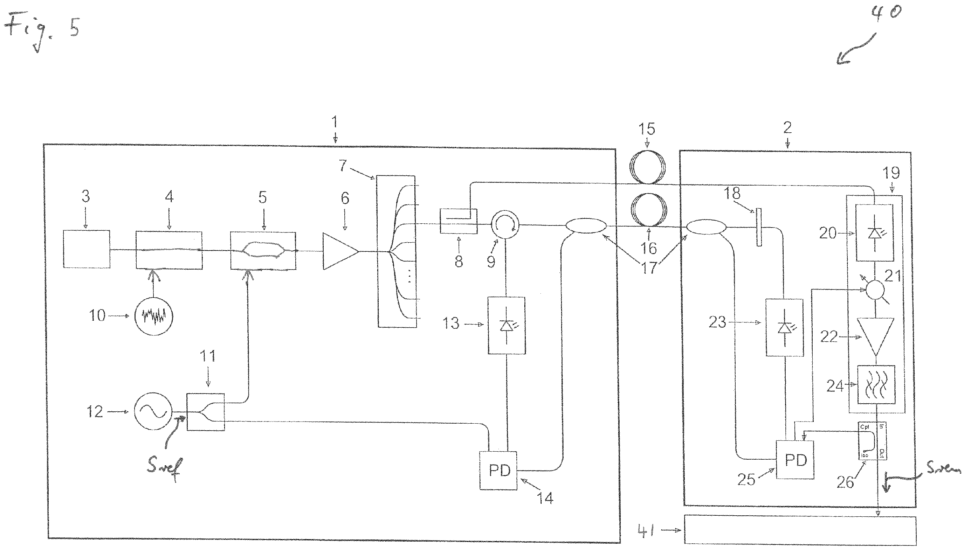

In FIG. 5, there is still another system 40 for synchronizing a reference signal Sref and a remote signal Srem. The system 40 is configured similarly to the system 40 in FIG. 4. The only difference with respect to the previous embodiment is that the sender 1 further includes an optical phase modulator 4, which is coupled to a source 10 of white noise. The optical phase modulator 4 is for broadening a carrier frequency spectrum of the laser beam, which is emitted by the laser 3. This is to reduce the interferometric noise generated in the fiber links 15, 16 caused by Rayleigh scattering.

The system 40, which is depicted in FIG. 6, includes an additional photo receiver 37 and an additional phase detector 38. The system is for synchronizing a reference signal Sref and a remote signal Srem and despite of the two mentioned additional components, the system 40 is configured similar to that in FIG. 5. The additional photo receiver 37 is coupled to the optical splitter 7 and receives the modulated and amplified laser beam, which is also coupled into the optical fiber 16 for transmission of the reference signal Sref to the receiver 2. The additional phase detector 38 receives the signal of the additional photo receiver 37 and is therefore configured for detection of drifts, which are due to the amplitude modulator 5, the amplifier 6 and the optical splitter 7.

The phase drift correction, which is performed by the system 40, will be explained in more detail by making reference to FIGs. 1 to 6.

The phase drifts, which are measured by the phase detectors having the reference numerals 38, 14 and 25 shall be referred to as $\varphi38$, $\varphi14$ and $\varphi25$, respectively.

The phase drift on the path from the power splitter 11 to the reflector 18 shall be referred to as $\varphi11\text{-}18$. This is measured by the phase detectors as follows:

$$\varphi11\text{-}18 = (\varphi14 - \varphi38) / 2 + \varphi38 = \varphi14 / 2 + \varphi38 / 2.$$

$\varphi25$ is the phase drift measured between the signal at the output of the optical link and the remote oscillator 36 by the phase detector 25. The phase drift between the reference oscillator 12 and the remote oscillator 36 shall be referred to as $\varphi12\text{-}36$. This is measured as follows:

$$\varphi12\text{-}36 = \varphi11\text{-}18 + \varphi25 = \varphi14 / 2 + \varphi38 / 2 + \varphi25.$$

The remote oscillator 36 is to be corrected by the phase drift $\varphi12\text{-}36$.

In the embodiment of FIG. 1, the phase of the remote signal source 19 is adjusted by directly adjusting the free oscillator 36. In the embodiments of FIGs. 2 to 6 this is performed using the phase shifter 21. However, according to further embodiments, which are not depicted in the figures, the phase is corrected digitally. In other words, the output signal of the remote signal source 19 can be input into a processing unit for digital correction of the phase. This advantageously applies to all embodiments of the invention.

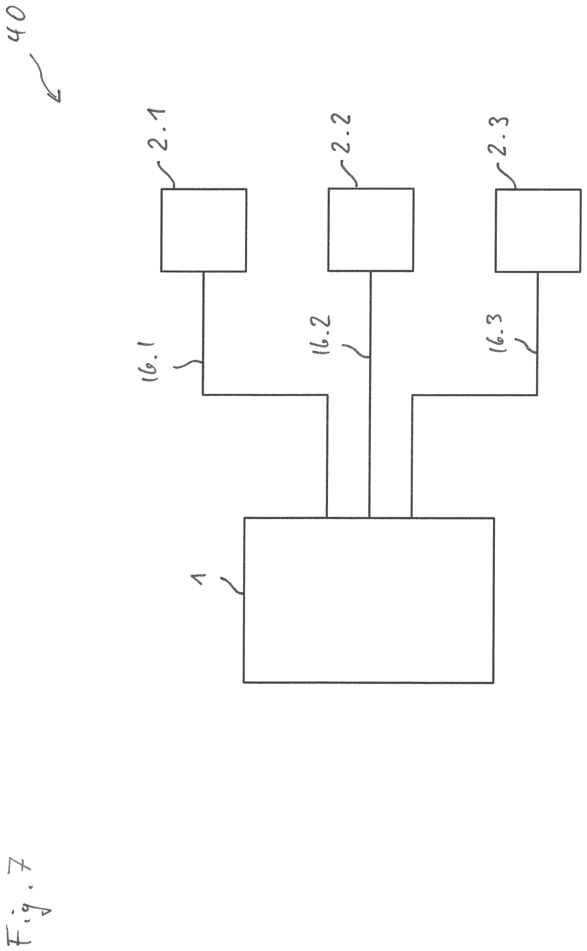

In FIG. 7, there is another system 40 for synchronizing a reference signal Sref and a remote signal Srem. The system 40 comprises a single sender 1 and a plurality of receivers 2.1, 2.2 and 2.3. The sender 1 and a respective one of the receivers 2 are linked via various optical fibers 16.1, 16.2 and 16.3. In the system 40 of FIG. 6, the sender 1 is configured identical to anyone of the senders 1, which are disclosed in the embodiments of FIGs. 1 to 6. Similarly, the receivers 2.1, 2.2 and 2.3 are configured identical to anyone of the receivers 2, which are disclosed in the embodiments of FIGs. 1 to 6. Naturally, the receivers 2.1, 2.2 and 2.3. in the system 40 of FIG. 7 are not necessarily identical, as long as they are suitable for communicating with the sender 1, the receivers 2.1, 2.2 and 2.3 can be configured according to different embodiments of FIGs. 1 to 6.

The optical fibers 16.1, 16.2, 16.3 are coupled to the optical splitter 7 in the sender 1 (cf. FIGs. 1 to 6). In addition to this, the sender 1 and the receivers 2.1, 2.2 and 2.3 can be linked by further optical fibers 16 or by data links 42, respectively. These connections are not shown in FIG. 7 only for simplification of the drawing.

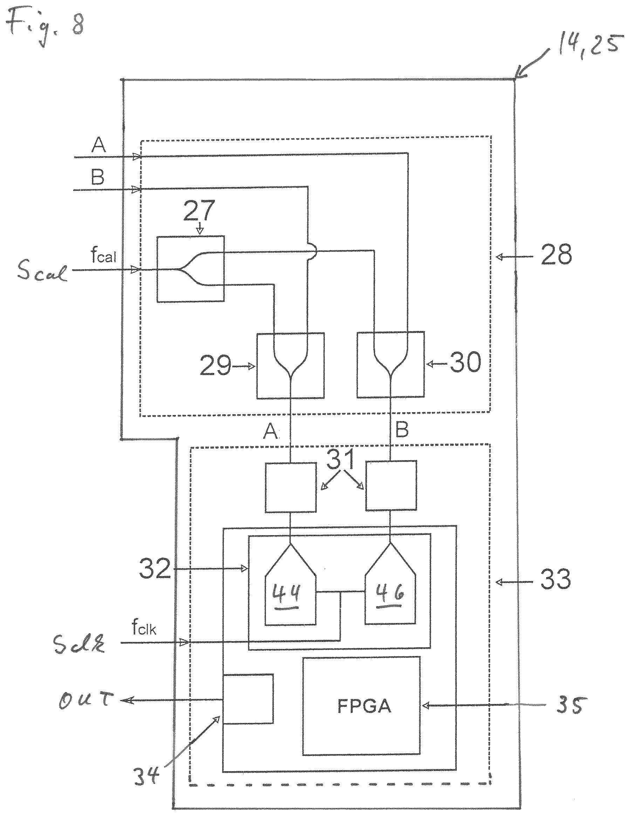

In FIG. 8, there is a simplified block or circuit diagram of a 360°-phase detector according to an embodiment of the invention. The phase detector 14 in the sender 1 and/or the phase detector 25 in the receiver 2 are preferably configured as the 360°-phase detector in FIG. 8. The 360°-phase detector 14, 25 has a first channel A and a second channel B. The 360°-phase detector 14, 25 comprises a phase detection part 33 and an optional calibration circuit 28. In other words, the 360°-phase detector 14, 25 can be implemented with the calibration circuit 28 omitted, according to an embodiment of the invention.

The phase detection part 33 has a first A/D-converter 44, which is in particular a direct RF-sampling A/D-converter. Furthermore, there is a second A/D-converter 46, which is also in particular a direct RF-sampling A/D-converter. At the input of channel A and B, there is an RF-front end 31 at each channel A, B. The RF-front ends can be implemented as filters and/or downconversion stages. When the 360°-phase detector 14, 25 is implemented without the calibration circuit 28, the input terminals of a respective one of the channels A, B are coupled to these RF-front ends 31. The analog front ends 31 of the phase detection part 33 in particular comprise bandpass filters and RF-transformers. However, the front ends 31 can also include microwave mixers. The bandwidth of the A/D converters equals usually a few GHz. If any application requires measurement of signals with higher frequencies, then mixers are applied for frequency downconversion to the A/D converter bandwidth.

The first A/D-converter 44 and the second A/D-converter 46 are configured to generate a first digital signal and a second digital signal, respectively, which are processed in a processing unit 35, which is for example an FPGA. The processing unit 35 processes the first and the second digital value and determines a difference between the two values, which is the phase difference between the signal at the first and the second channel A, B. The value of the phase difference is an output value OUT of the 360°-phase detector 14, 25 and it is provided at an output terminal 34.

The first and the second A/D-converter 44, 46 are housed in a common package 32 in that the first A/D-converter 44 and the second A/D-converter 46 experience almost identical environmental conditions, in particular with respect to temperature and/or humidity. The first and second A/D-converter 44, 46 are for example thermally coupled via a thermal bridge, which can be manufactured using copper or any other thermally highly conductive material. Furthermore, the two A/D-converters 44, 46 can be arranged in the package 32 in that they share a common leadframe, which serves as a thermal bridge between the two A/D-converters 44, 46. According to still another embodiment of the invention, the first A/D-converter 44 and the second A/D-converter 46 are manufactured on a single and common semiconductor substrate. The semiconductor substrate serves as a thermal bridge and consequently, the two A/D-converters 44, 46 are configured in that they can be operated at the same thermal conditions. Since the A/D-converters 44, 46 are embedded in a single and common uniform package 32, for example a mold, they will experience at least approximately the same humidity.

Operation of the A/D-converters 44, 46 under almost identical conditions renders the 360°-phase detector suitable for detection of phase differences over a full range of 360° ($2\pi$) with femtosecond precision. Since the output value OUT, which is provided at the output terminal 34, is the difference between the two digital values, which are generated by the first and the second A/D-converter 44, 46, the output value OUT will be at least approximately independent of external influences on the first and the second A/D-converter 44, 46. This is because external effects on the digital values, which are generated by the first and the second A/D-converter 44, 46, are identical for both converters - because they are operated under identical conditions - and therefore cancel out when considering the difference of the two digital values. Furthermore, the two A/D-converters 44, 46 are clocked using a common clock signal Sclk having a clock frequency fclk.

Temperature variations and input clock changes are identical for both input channels A, B. This allows for ultra-stable phase difference measurements of both channels A, B with respect to one another. In the A/D-converters 44, 46, the analog RF-signals, which are received at the input terminals of the phase detection part 33 are digitized by an IQ algorithm, the RF amplitude and the RF phase are extracted. The phase difference of the two RF input channels A, B contains the drift information and is digitally provided at the output 34.

When the 360°-phase detector 14, 25, which is depicted in FIG. 7, is implemented in the sender 1, it is configured to receive the reference signal at the first channel A and the signal of the back-reflected laser beam at the second channel B. When the 360°-phase detector is implemented in the receiver 2, which means that it is the further phase detector 25, it is configured to receive the remote signal Srem at the first channel A and the reference signal in the transmitted modulated laser beam at the second channel B. Naturally, the channels A, B can be coupled to the respective inputs vice versa.

The optional calibration circuit 28 of the 360°-phase detector 14, 25 comprises a splitter 27, which receives an RF calibrating signal Scal having frequency fcal. The splitter 27 splits up the calibrating signal Scal. Furthermore, there are combiners 29, 30 for superimposing the calibrating signal Scal and the input signals received at the first and the second channel A, B, respectively.

To eliminate potential drifts in the phase detector 14, 25 and to enhance its long-term stability, a two-tone calibration method is applied. This means, the calibrating signal Scal is used as the second tone. The calibration tone having the frequency fcal is detected by the A/D-converters 44, 46 and is decomposed in amplitude and phase simultaneously to the user signals at the channels A, B. Consequently, the calibration unit 28 is built drift-free and errors in the analog front ends 31 or residual differential drifts of the A/D-converters can be detected through the second tone fcal and digitally corrected for each channel A, B.

Advantageously, the system 40, and in particular the phase detector 14, 25, is configured to detect a phase difference in a femtosecond range. A femtosecond range, within the context of this specification, shall be between 1 and 100 femtoseconds. In particular, the system 40 and the phase detector 14, 25 are configured to detect a phase difference between 1 and 20 femtoseconds.

In a method of operating the system 40, the following steps are performed. Firstly, a phase difference between the reference signal Sref and a signal in the back-reflected laser beam, which is the transmitted modulated laser beam being reflected back through the optical fiber 16 from the receiver 2 to the sender 1 is detected using the phase detector 14 in the sender 1. In particular, a 360°- phase detector is applied. Subsequently, the value of the detected phase difference is communicated via the data link 42 from the sender 1 to the receiver 2. At the receiver 2, a further phase difference between the remote signal Srem and the reference signal Sref in the transmitted modulated laser beam is detected by the further phase detector 25. Again, the further phase detector 25 can be a 360°-phase detector. Finally, in the receiver 2, the detected value of the further phase difference is corrected by the value of the phase difference detected by the phase detector 14 of the sender 1. In other words, the phase error, which occurs during transmission of the reference signal Sref from the sender 1 to the receiver 2 due to variations on the fiber link 16 is corrected. The value of the phase error is received via the data link 42. Having performed this error correction step, synchronization of the reference signal Sref and the remote signal Srem is achieved.

All named characteristics, including those taken from the drawings alone, and individual characteristics, which are disclosed in combination with other characteristics, are considered alone and in combination as important to the invention. Embodiments according to the invention can be fulfilled through individual characteristics or a combination of several characteristics. Features which are combined with the wording "in particular" or "especially" are to be treated as preferred embodiments.


List of References

|  |  |
| --- | --- |
| 1 | sender |
| 2 | receiver |
| 3 | continuous wave laser |
| 4 | optical phase modulator |
| 5 | optical amplitude modulator |
| 6 | optical amplifier |
| 7 | optical splitter |
| 8 | further optical splitter |
| 9 | optical circulator |
| 10 | white noise source |
| 11 | microwave power splitter |
| 12 | reference oscillator |
| 13 | photo receiver |
| 14 | phase detector |
| 15 | further optical fiber |
| 16,16.1, 16.2, 16.3 | optical fiber |
| 17.1, 17.2 | multiplexer |
| 18 | optical reflector |
| 19 | remote signal source |
| 20 | further photo receiver |
| 21 | phase shifter |
| 22 | further amplifier |
| 23 | further photo receiver |
| 24 | narrow-band bandpass filter |
| 25 | further phase detector |
| 26 | microwave directional coupler |
| 27 | microwave power splitter |

| 28 | calibration circuit |
| 29, 30 | microwave power combiner |
| 31 | RF front end |
| 32 | package of an A/D converter |
| 33 | phase detection part |
| 34 | output terminal |
| 35 | processing unit |
| 36 | free oscillator |
| 37 | additional photo receiver |
| 38 | additional phase detector |
| 40 | system |
| 41 | consumer |
| 42 | data link |
| 43 | clock line |
| 44 | first A/D-converter |
| 46 | second A/D-converter |

| A | first channel |
| B | second channel |
| OUT | output signal |
| Sref | reference signal |
| Srem | remote signal |
| Sclk | clock signal |
| fclk | clock frequency |
| Scal | calibrating signal |
| fcal | calibrating frequency |

## Claims

1. A system (40) for synchronizing an oscillating reference signal, Sref, and an oscillating remote signal, Srem, the system (40) comprising a sender (1) with a reference oscillator (12) generating the reference signal (Sref) and a receiver (2) with a remote signal source (19) providing the remote signal (Srem), wherein the sender (1) and the receiver (2) are arranged remote from each other and are linked by an optical fiber (16), wherein the sender (1) further comprises:

   - a laser (3) for emission of a laser beam, including an optical coupler for coupling the laser beam into the optical fiber,
   - an optical amplitude modulator (5) being arranged downstream the laser (3) and being coupled to the reference oscillator (12) for amplitude modulating the laser beam with the reference signal, Sref, and the receiver (2) further comprises:
   - an optical reflector (18) arranged downstream a remote end of the optical fiber (16) emitting the transmitted modulated laser beam, wherein the reflector (18) is configured to partially reflect the transmitted modulated laser beam back through the optical fiber (16) towards the sender (1),

   **characterized in that**

   - the sender (1) comprises a phase detector (14) configured to detect a phase difference between the reference signal, Sref, and a signal in a back-reflected laser beam, which is the transmitted modulated laser beam being reflected back through the optical fiber (16) from the receiver (2) to the sender (1),
   - the sender (1) and the receiver (2) are coupled via a data link (42) and a value of the detected phase difference is communicated via the data link (42) from the sender (1) to the receiver (2),
   - the receiver (2) comprises a further phase detector (25) configured to detect a further phase difference between the remote signal, Srem, and the reference signal, Sref, in the transmitted modulated laser beam,
   - the receiver (2) is configured to correct the detected value of said further phase difference by the value of the phase difference detected by the phase detector (14) in the sender (1), said value being received via the data link (42), for synchronizing the reference signal, Sref, and the remote signal, Srem.

**2.** The system (40) according to claim 1, wherein the receiver (2) comprises a free oscillator (36) as the remote signal source (19) for generating the oscillating remote signal, Srem, wherein the further phase detector (25) is coupled to an output of the free oscillator (36) and to the optical fiber (16) so as to detect the further phase difference between the remote signal, Srem, and the reference signal, Sref, in the transmitted modulated laser beam, and wherein the free oscillator (36) is configured to receive the value of the phase difference detected by the phase detector (14) in the sender (1) via the data link (42) and the value of the phase difference detected by the phase detector (25) in the receiver(2) for synchronizing the reference signal , Sref, and the remote signal, Srem.

**3.** The system (40) according to claim 1, wherein the sender (1) and the receiver (2) are further linked by a clock line (15), which is in particular a further optical fiber, the clock line (15) being configured for transmission of the reference signal, Sref, to the remote signal source (19), wherein the remote signal source (19) comprises a phase shifter (21) and an amplifier (22) being coupled in series and being configured to receive the reference signal, Sref, as input via the clock line (15), wherein the remote signal source (19) is further configured to generate the remote signal, Srem, from the received reference signal, Sref, and wherein the phase shifter (21) is configured to receive the value of the phase difference detected by the phase detector (14) in the sender (1) via the data link (42) and the value of the phase difference detected by the phase detector (25) in the receiver (2) for synchronizing the reference signal, Sref, and the remote signal, Srem.

**4.** The system (40) according to anyone of the preceding claims, wherein the sender (1) and the receiver (2) each comprise a multiplexer (17.1, 17.2) being configured to couple the reference signal, Sref, and a data signal transmitted via the data link (42) into the optical fiber (16) in that the data link (42) between the sender (1) and the receiver (2) is established via said optical fiber (16), wherein in particular the multiplexers (17.1, 17.2) are wavelength division multiplexers.

**5.** The system (40) according to anyone of the preceding claims, wherein the sender (1) comprises an optical phase modulator (4) being arranged downstream the laser (3), in particular between the laser (3) and the optical modulator (5), the optical phase modulator (4) being configured to broaden a carrier frequency spectrum of the laser beam.

**6.** The system (40) according to anyone of the preceding claims, comprising a sender (1) and a plurality of receivers (2), wherein the sender (1) and the receivers (2) are arranged remote from each other and the sender (1) is linked to every receiver (2) by a separate optical fiber (16), wherein the sender (1) comprises an optical splitter (7) being arranged downstream the optical modulator (5), wherein the optical splitter (7) is configured to split up the modulated laser beam into a plurality of split-up modulated laser beams, wherein every split-up laser beam is coupled into one of the plurality of optical fibers (16).

**7.** The system (40) according to anyone of the preceding claims, wherein the optical fiber (16) is a single mode optical fiber, in particular polarization-maintaining optical fiber.

**8.** The system (40) according to anyone of the preceding claims, wherein the phase detector (14) in the sender (1) and/or the further phase detector (25) in the receiver (2) is a 360°-phase detector (14, 25) having a first channel, A, wherein the first channel, A, has a first A/D-converter (44) and the second channel, B, has a second A/D-converter (46), wherein the 360°-phase detector (14, 25) is configured to determine a 360°-phase value by comparing a first digital signal generated by the first A/D-converter (44) and a second digital signal generated by the second A/D-converter (46), wherein the first A/D-converter (44) and the second A/D-converter (46) are housed in a package (32) in that the first A/D-converter (44) and the second A/D-converter (46) experience the same environmental conditions, in particular the same environmental conditions with respect to temperature and/or humidity.

**9.** The system (40) according to claim 8, wherein the first A/D-converter (44) and the second A/D-converter (46) are thermally coupled via a thermal bridge, wherein in particular the first and the second A/D-converter (44, 46) share a common leadframe, and/or are manufactured on a single and common semiconductor substrate, wherein in particular the first and the second A/D-converter (44, 46) are thermally coupled in that they are operable at an at least approximately identical temperature, wherein further in particular, the first and the second A/D-converter (44, 46) are embedded in a single common an uniform mold in that the first and the second A/D-converter (44, 46) experience at least approximately the same humidity.

**10.** The system (40) according to claim 8 or 9, wherein the 360°-phase detector (14) in the sender (1) is configured to receive the reference signal, Sref, at the first channel, A, and the signal in the back-reflected laser beam at the second channel, B, and/or the further 360°-phase detector (25) in the receiver (2) is configured to receive the remote signal, Srem, at the first channel, A, and the reference signal, Sref, in the transmitted modulated laser beam at the second channel, B.

11. The system (40) according to anyone of claims 8 to 10, wherein the 360°-phase detector (14, 25) further comprises a splitter (27) configured to receive a calibrating signal, Scal, having a calibrating frequency, fcal, wherein the 360°-phase detector (14, 25) is further configured to couple the split-up calibrating signal, Scal, to the first channel, A, and to the second channel (B).

12. The system (40) according to anyone of the preceding claims, wherein the system (40) and in particular the 360°-phase detector (14, 25) are configured to detect a phase difference in a femtosecond range, in particular a phase difference, which is between 10 and 100 femtoseconds.

13. A method of operating the system (40) according to anyone of the preceding claims, the method being **characterized by** the following steps of:

    - detecting a phase difference between the reference signal, Sref, and a signal in the back-reflected laser beam, which is the transmitted modulated laser beam being reflected back through the optical fiber (16) from the receiver (2) to the sender (1), by the phase detector (14) of the sender (1),
    - transmitting the value of the detected phase difference via the data link (42) from the sender (1) to the receiver (2),
    - detecting a further phase difference between the remote signal, Srem, and the reference signal, Sref, in the transmitted modulated laser beam by the further phase detector (25) of the receiver (2),
    - in the receiver (2), correcting the detected value of said further phase difference by the value of the phase difference detected by the phase detector (14) of the sender (1), said value being received via the data link (42), thereby synchronizing the reference signal, Sref, and the remote signal, Srem.

14. The method of claim 13, wherein the sender (1) and the receiver (2) are further linked by a clock line (15) and the method further comprises the steps of:

    - transmitting the reference signal, Sref, via the clock line (15) to the remote signal source (19), wherein the remote signal source (19) of the receiver (2) further comprises a phase shifter and an amplifier being coupled in series,
    - the remote signal source (19) receives the reference signal, Sref, as input via the clock line (15) and generates the remote signal, Srem, from the received reference signal, Sref,
    - receiving the value of the phase difference detected by the phase detector (14) in the sender (1) and by the phase detector (25) in the receiver (2) at the phase shifter (21) in the receiver (2) via the data link (42) for synchronizing the reference signal, Sref, and the remote signal, Srem.

15. The method of claim 13 or 14, wherein the sender (1) comprises an optical phase modulator (4) being arranged downstream the laser (3), wherein a carrier frequency spectrum of the laser beam is broadened by the phase modulator (4).

16. The method according to anyone of claims 13 to 15, wherein the phase detector (14) in the sender (1) and/or the further phase detector (25) in the receiver (2) is a 360°-phase detector (14, 25) having a first channel, A, wherein the first channel, A, has a first A/D-converter (44) and the second channel, B, has a second A/D-converter (46), wherein the first A/D-converter (44) and the second A/D-converter (46) are housed in a package (32) in that the first A/D-converter (44) and the second A/D-converter (46) experience the same environmental conditions, in particular the same environmental conditions with respect to temperature and/or humidity and wherein a 360°-phase value is determined by comparing a first digital signal generated by the first A/D-converter (44) and a second digital signal generated by the second A/D-converter (46).

17. The method according to claim 16, wherein the 360°-phase detector (14) in the sender (1) receives the reference signal, Sref, at the first channel, A, and the signal in the back-reflected laser beam at the second channel, B, and/or the further 360°- phase detector (25) in the receiver (2) receives the remote signal, Srem, at the first channel, A, and the reference signal, Sref, in the transmitted modulated laser beam at the second channel, B.

**Patentansprüche**

1. System (40) zum Synchronisieren eines oszillierenden Referenzsignals, Sref, und eines oszillierenden Fernsignals, Srem, wobei das System (40) einen Sender (1) mit einem Referenzoszillator (12), der das Referenzsignal (Sref) erzeugt, und einen Empfänger (2) mit einer Fernsignalquelle (19) umfasst, die das Fernsignal (Srem) bereitstellt, wobei der Sender (1) und der Empfänger (2) voneinander entfernt angeordnet sind und durch einen Lichtwellenleiter (16) verbunden sind, wobei
der Sender (1) überdies Folgendes umfasst:

   - einen Laser (3) zum Aussenden eines Laserstrahls, der einen Optokoppler zum Koppeln des Laserstrahls in den Lichtwellenleiter umfasst,
   - einen optischen Amplitudenmodulator (5), der dem Laser (3) nachgeschaltet angeordnet ist und zur Amplitudenmodulation des Laserstrahls mit dem Referenzsignal, Sref, an den Referenzoszillator (12) gekoppelt ist, und

   der Empfänger (2) überdies Folgendes umfasst:

   - einen optischen Reflektor (18), der einem entfernt gelegenen Ende des Lichtwellenleiters (16), der den übertragenen modulierten Laserstrahl ausstrahlt, nachgeschaltet angeordnet ist, wobei der Reflektor (18) ausgestaltet ist, den übertragenen modulierten Laserstrahl teilweise durch den Lichtwellenleiter (16) in Richtung Sender (1) zurückzureflektieren,

   **dadurch gekennzeichnet, dass**

   - der Sender (1) einen Phasendetektor (14) umfasst, der ausgestaltet ist, eine Phasendifferenz zwischen dem Referenzsignal, Sref, und einem Signal in einem zurückreflektierten Laserstrahl zu detektieren, welcher der übertragene modulierte Laserstrahl ist, der durch den Lichtwellenleiter (16) vom Empfänger (2) zum Sender (1) zurückreflektiert wird,
   - der Sender (1) und der Empfänger (2) über eine Datenverbindung (42) gekoppelt sind und ein Wert der detektierten Phasendifferenz vom Sender (1) über die Datenverbindung (42) dem Empfänger (2) mitgeteilt wird,
   - der Empfänger (2) einen weiteren Phasendetektor (25) umfasst, der ausgestaltet ist, eine weitere Phasendifferenz zwischen dem Fernsignal, Srem, und dem Referenzsignal, Sref, im übertragenen modulierten Laserstrahl zu detektieren,
   - der Empfänger (2) ausgestaltet ist, den detektierten Wert der weiteren Phasendifferenz durch den Wert der Phasendifferenz, der von dem Phasendetektor (14) im Sender (1) detektiert wurde, zu korrigieren, wobei der Wert zum Synchronisieren des Referenzsignals, Sref, und des Fernsignals, Srem, über die Datenverbindung (42) empfangen wird.

2. System (40) nach Anspruch 1, wobei der Empfänger (2) einen freien Oszillator (36) als Fernsignalquelle (19) zum Erzeugen des oszillierenden Fernsignals, Srem, umfasst,
wobei der weitere Phasendetektor (25) an einen Ausgang des freien Oszillators (36) und an den Lichtwellenleiter (16) gekoppelt ist, um die weitere Phasendifferenz zwischen dem Fernsignal, Srem, und dem Referenzsignal, Sref, im übertragenen modulierten Laserstrahl zu detektieren, und wobei der freie Oszillator (36) ausgestaltet ist, den Wert der Phasendifferenz, der von dem Phasendetektor (14) in dem Sender (1) detektiert wurde, über die Datenverbindung (42) und den Wert der Phasendifferenz, der von dem Phasendetektor (25) in dem Empfänger (2) detektiert wurde, zum Synchronisieren des Referenzsignals, Sref, und des Fernsignals, Srem, zu empfangen.

3. System (40) nach Anspruch 1, wobei der Sender (1) und der Empfänger (2) überdies durch eine Taktleitung (15) verbunden sind, die insbesondere ein weiterer Lichtwellenleiter ist, wobei die Taktleitung (15) zum Übertragen des Referenzsignals, Sref, an die Fernsignalquelle (19) ausgestaltet ist, wobei die Fernsignalquelle (19) einen Phasenschieber (21) und einen Verstärker (22) umfasst, die in Serie geschaltet und ausgestaltet sind, das Referenzsignal, Sref, als Eingang über die Taktleitung (15) zu empfangen, wobei die Fernsignalquelle (19) überdies ausgestaltet ist, das Fernsignal, Srem, aus dem empfangenen Referenzsignal, Sref, zu erzeugen,
und wobei der Phasenschieber (21) ausgestaltet ist, den Wert der Phasendifferenz, der von dem Phasendetektor (14) in dem Sender (1) detektiert wurde, über die Datenverbindung (42) und den Wert der Phasendifferenz, der von dem Phasendetektor (25) in dem Empfänger (2) detektiert wurde, zum Synchronisieren des Referenzsignals, Sref, und des Fernsignals, Srem. zu empfangen.

4. System (40) nach einem der vorhergehenden Ansprüche, wobei der Sender (1) und der Empfänger (2) jeweils einen Multiplexer (17.1, 17.2) umfassen, der ausgestaltet ist, das Referenzsignal, Sref, und ein Datensignal zu koppeln, das über die Datenverbindung (42) in den Lichtwellenleiter (16) übertragen wird, indem über den Lichtwellenleiter (16) die Datenverbindung (42) zwischen dem Sender (1) und dem Empfänger (2) hergestellt wird, wobei insbesondere die Multiplexer (17.1, 17.2) Wellenlängenmultiplexer sind.

5. System (40) nach einem der vorhergehenden Ansprüche, wobei der Sender (1) einen optischen Phasenmodulator (4) umfasst, der dem Laser (3) nachgeschaltet angeordnet ist, insbesondere zwischen dem Laser (3) und dem optischen Modulator (5), wobei der optische Phasenmodulator (4) ausgestaltet ist, ein Trägerfrequenzspektrum des Laserstrahls zu erweitern.

6. System (40) nach einem der vorhergehenden Ansprüche, das einen Sender (1) und eine Vielzahl von Empfängern (2) umfasst, wobei der Sender (1) und die Empfänger (2) voneinander entfernt angeordnet sind, und der Sender (1) mit jedem Empfänger (2) durch einen separaten Lichtwellenleiter (16) verbunden ist, wobei der Sender (1) einen optischen Verteiler (7) umfasst, der dem optischen Modulator (5) nachgeschaltet angeordnet ist, wobei der optische Verteiler (7) ausgestaltet ist, den modulierten Laserstrahl in eine Vielzahl von aufgeteilten modulierten Laserstrahlen aufzuteilen, wobei jeder aufgeteilte Laserstrahl in einen der Vielzahl von Lichtwellenleitern (16) gekoppelt wird.

7. System (40) nach einem der vorhergehenden Ansprüche, wobei der Lichtwellenleiter (16) ein Einmoden-Lichtwellenleiter ist, insbesondere ein polarisationserhaltender Lichtwellenleiter.

8. System (40) nach einem der vorhergehenden Ansprüche, wobei der Phasendetektor (14) im Sender (1) und/oder der weitere Phasendetektor (25) im Empfänger (2) ein 360°-Phasendetektor (14, 25) ist, der einen ersten Kanal, A, aufweist, wobei der erste Kanal, A, einen ersten A/D-Wandler (44) aufweist, und der zweite Kanal, B, einen zweiten A/D-Wandler (46) aufweist, wobei der 360°-Phasendetektor (14, 25) ausgestaltet ist, durch Vergleichen eines ersten digitalen Signals, das von dem ersten A/D-Wandler (44) erzeugt wird, und eines zweiten digitalen Signals, das von dem zweiten A/D-Wandler (46) erzeugt wird, einen 360°-Phasenwert zu bestimmen, wobei der erste A/D-Wandler (44) und der zweite A/D-Wandler (46) in einer Verpackung (32) gelagert sind, in der der erste A/D-Wandler (44) und der zweite A/D-Wandler (46) die gleichen Umgebungsbedingungen erfahren, insbesondere die gleichen Umgebungsbedingungen in Bezug auf Temperatur und/oder Feuchtigkeit.

9. System (40) nach Anspruch 8, wobei der erste A/D-Wandler (44) und der zweite A/D-Wandler (46) thermisch über eine Wärmebrücke gekoppelt sind, wobei insbesondere der erste und der zweite A/D-Wandler (44, 46) einen gemeinsamen Leitungsrahmen teilen, und/oder auf einem einzigen und gemeinsamen Halbleitersubstrat gefertigt sind, wobei insbesondere der erste und der zweite A/D-Wandler (44, 46) thermisch gekoppelt sind, so dass sie bei einer zumindest annähernd identischen Temperatur betriebsfähig sind, wobei überdies insbesondere der erste und der zweite A/D-Wandler (44, 46) in eine einzige gemeinsame und einheitliche Form eingebettet sind, in der der erste und der zweite A/D-Wandler (44, 46) zumindest annähernd die gleiche Feuchtigkeit erfahren.

10. System (40) nach Anspruch 8 oder 9, wobei der 360°-Phasendetektor (14) im Sender (1) ausgestaltet ist, das Referenzsignal, Sref, auf dem ersten Kanal, A, und das Signal im zurückreflektierten Laserstrahl auf dem zweiten Kanal, B, zu empfangen, und/oder der weitere 360°-Phasendetektor (25) im Empfänger (2), ausgestaltet ist, das Fernsignal, Srem, auf dem ersten Kanal, A, und das Referenzsignal, Sref, im übertragenen modulierten Laserstrahl auf dem zweiten Kanal, B, zu empfangen.

11. System (40) nach einem der Ansprüche 8 bis 10, wobei der 360°-Phasendetektor (14, 25) überdies einen Verteiler (27) umfasst, der ausgestaltet ist, ein Kalibrierungssignal, Scal, zu empfangen, das eine Kalibrierungsfrequenz, fcal, aufweist, wobei der 360°-Phasendetektor (14, 25) überdies ausgestaltet ist, das aufgeteilte Kalibrierungssignal, Scal, an den ersten Kanal, A, und an den zweiten Kanal (B) zu koppeln.

12. System (40) nach einem der vorhergehenden Ansprüche, wobei das System (40) und insbesondere der 360°-Phasendetektor (14, 25) ausgestaltet sind, eine Phasendifferenz in einem Femtosekundenbereich zu detektieren, insbesondere eine Phasendifferenz, die zwischen 10 und 100 Femtosekunden liegt.

13. Verfahren zum Betreiben des Systems (40) nach einem der vorhergehenden Ansprüche, wobei das Verfahren durch die folgenden Schritte gekennzeichnet ist:

> - Detektieren einer Phasendifferenz zwischen dem Referenzsignal, Sref, und einem Signal im zurückreflektierten Laserstrahl, welcher der übertragene modulierte Laserstrahl ist, der vom Phasendetektor (14) des Senders (1) durch den Lichtwellenleiter (16) vom Empfänger (2) zum Sender (1) zurückreflektiert wird,

- Übertragen des Wertes der detektierten Phasendifferenz über die Datenverbindung (42) vom Sender (1) zum Empfänger (2),

- Detektieren einer weiteren Phasendifferenz zwischen dem Fernsignal, Srem, und dem Referenzsignal, Sref, im übertragenen modulierten Laserstrahl durch den weiteren Phasendetektor (25) des Empfängers (2)

- Korrigieren des detektierten Wertes der weiteren Phasendifferenz im Empfänger (2) durch den Wert der Phasendifferenz, der von dem Phasendetektor (14) des Senders (1) detektiert wurde, wobei der Wert über die Datenverbindung (42) empfangen wird, wodurch das Referenzsignal, Sref, und das Fernsignal, Srem, synchronisiert werden.

**14.** Verfahren nach Anspruch 13, wobei der Sender (1) und der Empfänger (2) überdies durch eine Taktleitung (15) verbunden sind und das Verfahren überdies die folgenden Schritte umfasst:

- Übertragen des Referenzsignals, Sref, über die Taktleitung (15) an die Fernsignalquelle (19), wobei die Fernsignalquelle (19) des Empfängers (2) überdies einen Phasenschieber und einen Verstärker umfasst, die in Serie geschaltet sind,

- die Fernsignalquelle (19) empfängt das Referenzsignal, Sref, als Eingang über die Taktleitung (15) und erzeugt aus dem empfangenen Referenzsignal, Sref, das Fernsignal, Srem,

- Empfangen des Werts der Phasendifferenz, der vom Phasendetektor (14) im Sender (1) und vom Phasendetektor (25) im Empfänger (2) detektiert wurde, am Phasenschieber (21) im Empfänger (2) über die Datenverbindung (42) zum Synchronisieren des Referenzsignals, Sref, und des Fernsignals, Srem.

**15.** Verfahren nach Anspruch 13 oder 14, wobei der Sender (1) einen optischen Phasenmodulator (4) umfasst, der dem Laser (3) nachgeschaltet angeordnet ist, wobei ein Trägerfrequenzspektrum des Laserstrahls vom Phasenmodulator (4) erweitert wird.

**16.** Verfahren nach einem der Ansprüche 13 bis 15, wobei der Phasendetektor (14) im Sender (1) und/oder der weitere Phasendetektor (25) im Empfänger (2) ein 360°-Phasendetektor (14, 25) ist, der einen ersten Kanal, A, aufweist, wobei der erste Kanal, A, einen ersten A/D-Wandler (44) aufweist und der zweite Kanal, B, einen zweiten A/D-Wandler (46) aufweist, wobei der erste A/D-Wandler (44) und der zweite A/D-Wandler (46) in einer Verpackung (32) gelagert sind, in der der erste A/D-Wandler (44) und der zweite A/D-Wandler (46) die gleichen Umgebungsbedingungen erfahren, insbesondere die gleichen Umgebungsbedingungen in Bezug auf Temperatur und/oder Feuchtigkeit, und wobei ein 360°-Phasenwert durch Vergleichen eines ersten digitalen Signals, das von dem ersten A/D-Wandler (44) erzeugt wird, und eines zweiten digitalen Signals, das von dem zweiten A/D-Wandler (46) erzeugt wird, bestimmt wird.

**17.** Verfahren nach Anspruch 16, wobei der 360°-Phasendetektor (14) im Sender (1) das Referenzsignal, Sref, auf dem ersten Kanal, A, und das Signal im zurückreflektierten Laserstrahl auf dem zweiten Kanal, B, empfängt, und/oder der weitere 360°-Phasendetektor (25) im Empfänger (2) das Fernsignal, Srem, auf dem ersten Kanal, A, und das Referenzsignal, Sref, im übertragenen modulierten Laserstrahl auf dem zweiten Kanal, B, empfängt.

**Revendications**

**1.** Un système (40) pour synchroniser un signal de référence oscillant, Sref, et un signal distant oscillant, Srem, le système comprenant un émetteur (1) avec un oscillateur de référence (12) générant le signal de référence (Sref) et un récepteur (2) avec une source de signal distante (19) fournissant le signal distant (Srem), dans lequel l'émetteur (1) et le récepteur (2) sont disposés à distance l'un de l'autre et sont reliés par une fibre optique (16), l'émetteur (1), dans lequel

le système comprend en outre :

- un laser (3) pour l'émission d'un faisceau laser, incluant un coupleur optique pour relier le faisceau laser à la fibre optique,

- un modulateur d'amplitude optique (5) disposé en aval du laser et étant relié à l'oscillateur de référence (12) pour moduler en amplitude le faisceau laser avec le signal de référence, Sref,

et le récepteur (2) comprenant en outre :

- un réflecteur optique (18) disposé en aval d'une extrémité distante de la fibre optique (16) émettant le faisceau laser modulé transmis, le réflecteur (18) étant configuré pour réfléchir partiellement le faisceau laser modulé transmis, en retour vers l'émetteur (1), à travers la fibre optique (16),

**caractérisé en ce que**

- l'émetteur (1) comprend un détecteur de phase (14) configuré pour détecter une différence de phase entre le signal de référence, Sref, et un signal du faisceau laser rétro-réfléchi, qui est le faisceau laser modulé transmis qui est réfléchi en retour depuis le récepteur (2) vers l'émetteur (1) à travers la fibre optique (16),
- l'émetteur (1) et le récepteur (2) sont reliés par une liaison de données (42) et une valeur de la différence de phase détectée est communiquée par la liaison de données (42) depuis l'émetteur (1) vers le récepteur (2),
- le récepteur (2) comprend un autre détecteur de phase (25) configuré pour détecter une autre différence de phase entre le signal distant, Srem, et le signal de référence, Sref, dans le faisceau laser modulé transmis,
- le récepteur (2) est configuré pour corriger la valeur détectée de ladite autre différence de phase par la valeur de la différence de phase détectée par le détecteur de phase (14) dans l'émetteur (1), ladite valeur étant reçue via la liaison de données (42) pour synchroniser le signal de référence, Sref, et le signal distant, Srem.

2. Le système (40) selon la revendication 1, dans lequel le récepteur (2) comprend un oscillateur libre (36) en tant que source distante (19) de signal pour générer le signal oscillant distant, Srem, le détecteur de phase supplémentaire (25) est relié à une sortie de l'oscillateur libre (36) et à la fibre optique (16) de manière à détecter ladite autre différence de phase entre le signal distant, Srem, et le signal de référence, Sref, dans le faisceau laser modulé transmis, et l'oscillateur libre (36) étant configuré pour recevoir la valeur de la différence de phase détectée par le détecteur de phase (14) dans l'émetteur (1) via la liaison de données (42) et la valeur de la différence de phase détectée par le détecteur de phase (25) dans le récepteur (2) pour synchroniser le signal de référence, Sref, et le signal distant, Srem.

3. Le système (40) selon la revendication 1, dans lequel l'émetteur (1) et le récepteur (2) sont reliés entre eux par une ligne d'horloge (15), qui est en particulier une autre fibre optique, la ligne d'horloge (15) étant configurée pour la transmission du signal de référence, Sref, à la source de signal distant (19), la source de signal distant (19) comprenant un déphaseur (21) et un amplificateur (22) reliés en série et configurés pour recevoir le signal de référence Sref, en tant qu'entrée, via la ligne d'horloge (15), la source de signal distant (19) étant en outre configurée pour générer le signal distant, Srem, à partir du signal de référence reçu, Sref, et le déphaseur (21) étant configuré pour recevoir la valeur de la différence de phase détectée par le détecteur de phase (14) dans l'émetteur (1) via la liaison de données (42) et la valeur de la différence de phase détectée par le détecteur de phase (25) dans le récepteur (2) pour synchroniser le signal de référence, Sref, et le signal distant, Srem.

4. Le système (40) selon l'une quelconque des revendications précédentes, dans lequel l'émetteur (1) et le récepteur (2) comprennent chacun un multiplexeur (17.1, 17.2) configuré pour coupler le signal de référence, Sref, et un signal de données transmis par la liaison de données (42) dans la fibre optique (16), de sorte que la liaison de données (42) entre l'émetteur (1) et le récepteur (2) est établie par ladite fibre optique (16), les multiplexeurs (17.1, 17.2) étant en particulier des multiplexeurs à répartition en longueur d'onde.

5. Le système (40) selon l'une quelconque des revendications précédentes, dans lequel l'émetteur (1) comprend un modulateur de phase optique (4) agencé en aval du laser (3), notamment entre le laser (3) et le modulateur optique (5), le modulateur de phase optique (4) étant configuré pour élargir un spectre de fréquence porteuse du faisceau laser.

6. Le système (40) selon l'une quelconque des revendications précédentes, comprenant un émetteur (1) et une pluralité de récepteurs (2), dans lequel l'émetteur (1) et les récepteurs (2) sont agencés à distance l'un de l'autre, et l'émetteur (1) est relié à chaque récepteur (2) par une fibre optique (16) distincte, l'émetteur (1) comprenant un diviseur optique (7) agencé en aval du modulateur optique (5), le diviseur optique (7) étant configuré pour diviser le faisceau laser modulé en une pluralité de faisceaux laser modulés divisés, chaque faisceau laser divisé étant relié à l'une des fibres optiques (16) parmi la pluralité de fibres optiques.

7. Le système (40) selon l'une quelconque des revendications précédentes, dans lequel la fibre optique (16) est une fibre optique monomode, en particulier une fibre optique de maintien de la polarisation.

8. Le système (40) selon l'une quelconque des revendications précédentes, dans lequel le détecteur de phase (14) dans l'émetteur (1) et / ou le détecteur de phase supplémentaire (25) dans le récepteur (2) est un détecteur de phase (14, 25) à 360° ayant un premier canal, A, le premier canal A ayant un premier convertisseur A/N (44) et le deuxième canal, B, ayant un deuxième convertisseur A/N (46), le détecteur à phase (14, 25) à 360° étant configuré pour déterminer une valeur de phase à 360° en comparant un premier signal numérique généré par le premier convertisseur A/N (44) et un deuxième signal numérique généré par le deuxième convertisseur A/N (46), le premier convertisseur A/N (44) et le deuxième convertisseur A/N / (46) étant logés dans un boîtier (32) de sorte que le premier convertisseur A/N (44) et le deuxième convertisseur A/N (46) subissent les mêmes conditions environnementales, en particulier les mêmes conditions environnementales en ce qui concerne la température et / ou l'humidité.

9. Le système (40) selon la revendication 8, dans lequel le premier convertisseur A/N (44) et le deuxième convertisseur A/N (46) sont reliés thermiquement par un pont thermique, le premier et le deuxième convertisseur A/N (44, 46) partageant en particulier une grille de connexion commune et / ou étant fabriqués sur un substrat semi-conducteur unique et commun, le premier et le deuxième convertisseur A/N (44, 46) étant en particulier reliés thermiquement de sorte qu'ils peuvent fonctionner à une température au moins approximativement identique, le premier et le deuxième convertisseur A/N (44, 46) étant incorporés dans un seul moule uniforme et commun, de sorte que le premier et le deuxième convertisseur A/N (44, 46) subissent au moins approximativement la même humidité.

10. Le système (40) selon la revendication 8 ou la revendication 9, dans lequel le détecteur de phase à 360° (14) dans l'émetteur (1) est configuré pour recevoir le signal de référence, Sref, sur le premier canal A, et le signal du faisceau laser rétro-réfléchi sur le deuxième canal B et / ou le détecteur supplémentaire de phase (25) à 360° présent dans le récepteur (2) est configuré pour recevoir le signal distant, Srem, au niveau du premier canal, A, et le signal de référence, Sref, dans le faisceau laser modulé transmis sur le deuxième canal, B.

11. Le système (40) selon l'une quelconque des revendications 8 à 10, dans lequel le détecteur de phase (14, 25) à 360° comprend en outre un diviseur (27) configuré pour recevoir un signal d'étalonnage, Scal, ayant une fréquence d'étalonnage, fcal, le détecteur de phase (14, 25) à 360° étant en outre configuré pour coupler le signal d'étalonnage divisé, Scal, au premier canal, A, et au deuxième canal, B.

12. Le système (40) selon l'une quelconque des revendications précédentes, dans lequel le système (40), et en particulier le détecteur de phase (14, 25) à 360°, sont configurés pour détecter une différence de phase de l'ordre de la femto-seconde, en particulier une différence de phase qui est comprise entre 10 et 100 femto-secondes.

13. Un procédé de fonctionnement du système (40) selon l'une quelconque des revendications précédentes, le procédé étant **caractérisé par** les étapes suivantes, consistant à :

    - détecter une différence de phase entre le signal de référence, Sref, et un signal dans le faisceau laser rétro-réfléchi, qui est le faisceau laser modulé transmis qui est réfléchi à travers la fibre optique (16) depuis le récepteur (2) vers l'émetteur (1), par le détecteur de phase (14) de l'émetteur (1),
    - transmettre la valeur de la différence de phase détectée via la liaison de données (42) depuis l'émetteur (1) vers le récepteur (2),
    - détecter une autre différence de phase entre le signal distant, Srem, et le signal de référence, Sref, dans le faisceau laser modulé transmis par le détecteur de phase supplémentaire (25) du récepteur (2),
    - dans le récepteur (2), corriger la valeur détectée de ladite autre différence de phase par la valeur de la différence de phase détectée par le détecteur de phase (14) de l'émetteur (1), ladite valeur étant reçue par la liaison de données (42), synchronisant ainsi le signal de référence, Sref, et le signal distant, Srem.

14. Le procédé selon la revendication 13, dans lequel l'émetteur (1) et le récepteur (2) sont en outre reliés par une ligne d'horloge (15) et le procédé comprend en outre les étapes consistant à :

    - transmettre le signal de référence, Sref, via la ligne d'horloge (15) à la source de signal distant (19), la source de signal distant (19) du récepteur (2) comprenant en outre un déphaseur et un amplificateur reliés en série,
    - la source de signal distant (19) reçoit le signal de référence, Sref, en tant qu'entrée via la ligne d'horloge (15) et génère le signal distant, Srem, à partir du signal de référence reçu, Sref,
    - recevoir la valeur de la différence de phase détectée par le détecteur de phase (14) dans l'émetteur (1) et par le détecteur de phase (25) dans le récepteur (2) au niveau du déphaseur (21) dans le récepteur (2) via la liaison de données (42) pour synchroniser le signal de référence, Sref, et le signal distant, Srem.

15. Le procédé selon la revendication 13 ou la revendication 14, dans lequel l'émetteur (1) comprend un modulateur de phase optique (4) agencé en aval du laser (3), un spectre de fréquence porteuse du faisceau laser étant élargi par le modulateur de phase (4).

16. Le procédé selon l'une quelconque des revendications 13 à 15, dans lequel le détecteur de phase (14) présent dans l'émetteur (1) et / ou le détecteur de phase (25) supplémentaire présent dans le récepteur (2) est un détecteur de phase (14, 25) à 360° ayant un premier canal, A, le premier canal, A, possédant un premier convertisseur A/N (44) et le deuxième canal, B, possédant un deuxième convertisseur A/N (46), le premier convertisseur A/N (44) et le deuxième convertisseur A/N (46) étant logés dans un boîtier (32) de sorte que le premier convertisseur A/N (44) et le deuxième convertisseur A/N (46) subissent les mêmes conditions environnementales, en particulier les mêmes conditions environnementales en ce qui concerne la température et / ou l'humidité, et une valeur de phase à 360° étant déterminée en comparant un premier signal numérique généré par le premier convertisseur A/N (44) et un deuxième signal numérique généré par le deuxième convertisseur A/N (46).

17. Le procédé selon la revendication 16, dans lequel le détecteur de phase à 360° (14) présent dans l'émetteur (1) reçoit le signal de référence, Sref, sur le premier canal, A, et le signal dans le faisceau laser rétro-réfléchi sur le deuxième canal, B, et / ou le détecteur de phase à 360° (25) supplémentaire présent dans le récepteur (2) reçoit le signal distant, Srem, sur le premier canal, A, et le signal de référence, Sref, dans le faisceau laser modulé transmis sur le deuxième canal, B.

Fig. 1

Fig. 2

EP 3 070 874 B1

Fig. 3

EP 3 070 874 B1

Fig. 4

EP 3 070 874 B1

Fig. 5

EP 3 070 874 B1

Fig. 6

Fig. 7

EP 3 070 874 B1

Fig. 8

14,25

A

B

27

S_cal    $f_{cal}$

28

29→    →30

A    B

31

32    33

$f_{clk}$
S_clk

OUT    FPGA    35

34

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **WILCOX, R.** *Optics Letters,* October 2009, vol. 34 (20), 3050-3052